(19) Europäisches Patentamt / European Patent Office / Office européen des brevets

(11) **EP 2 701 185 B1**

(12) **FASCICULE DE BREVET EUROPEEN**

(45) Date de publication et mention
de la délivrance du brevet:
**08.11.2017   Bulletin 2017/45**

(51) Int Cl.:
*H01L 21/265* (2006.01)      *H01L 21/762* (2006.01)

(21) Numéro de dépôt: **13177241.0**

(22) Date de dépôt: **19.07.2013**

(54) **PROCÉDÉ DE TRANSFERT D'UN FILM D'InP**

VERFAHREN ZUR ÜBERTRAGUNG EINER InP-SCHICHT

METHOD OF TRANSFERRING AN InP FILM

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:   **23.08.2012   FR 1257969**

(43) Date de publication de la demande:
**26.02.2014   Bulletin 2014/09**

(73) Titulaire: **COMMISSARIAT À L'ÉNERGIE
ATOMIQUE ET AUX
ÉNERGIES ALTERNATIVES
75015 Paris (FR)**

(72) Inventeur: **Tauzin, Aurélie
38120 ST EGREVE (FR)**

(74) Mandataire: **Delorme, Nicolas et al
Cabinet Germain & Maureau
BP 6153
69466 Lyon Cedex 06 (FR)**

(56) Documents cités:
**EP-A2- 1 408 545        WO-A2-2005/060723
US-A1- 2008 311 686**

## Description

La présente invention concerne un procédé de transfert d'un film d'InP sur un substrat raidisseur.

Dans le cadre de la technologie Smart Cut™, la fracture d'un substrat peut être influencée par de nombreux facteurs tels que la nature des ions implantés, l'énergie d'implantation, la dose implantation, le courant d'implantation (ou densité de courant, c'est-à-dire le ratio courant/surface implantée) et la température d'implantation.

Les conditions d'implantation d'ions H$^+$ compatibles avec une fracture sont bien connues et éprouvées pour le silicium, notamment dans le cas d'une fracture provoquée thermiquement. Ainsi, l'énergie d'implantation est choisie en fonction de l'épaisseur des couches que l'on souhaite transférer. La dose d'implantation dépend de l'énergie d'implantation : la dose minimale varie typiquement entre $4^E16$ H/cm$^2$ et $6^E16$ H/cm$^2$ quand l'énergie varie entre 30keV et 210keV. Le courant d'implantation peut être modifié entre quelques μA et quelques mA sans impact très important sur l'étape de fracture : en effet les seules influences du courant d'implantation sur le procédé sont une légère variation du traitement thermique de fracture à appliquer et/ou de l'épaisseur transférée et/ou de la rugosité de la surface obtenue après fracture. De même, la température d'implantation, c'est-à-dire la température atteinte dans le substrat au niveau du plan de fragilisation formé par les espèces implantées, peut varier entre -190°C et +300°C sans impact bloquant sur l'étape de fracture, tout comme pour le courant d'implantation, la température d'implantation du procédé n'influe que légèrement sur le traitement thermique de fracture à appliquer et/ou l'épaisseur transférée et/ou la rugosité de la surface obtenue après fracture.

Dans le cas de l'InP, il est connu d'après différents documents que la fracture et la qualité des films transférés dépendent fortement de la température d'implantation, voir par exemple le document US2008/311686. Dans l'article 'Low temperature InP layer transfer' de Q.-Y. Tong, Y.-L. Chao, L.-J. Haung, and U. Gösele, Electron.Lett. 35, 341 (1999), il est indiqué que la température d'implantation optimale pour l'InP est de l'ordre de 150 à 200°C tandis que dans 'Temperature dependence of hydrogen-induced exfoliation of InP', de S. Hayashi, D. Bruno, M.S.Goorsky, paru dans Appl. Phys. Lett., Vol. 85, No. 2, 12 July 2004, p236-238, il est indiqué que la température optimale est de -20°C. Ces différences d'évaluation peuvent provenir de paramètres non contrôlés par les auteurs de ces articles, tels que le dopage des substrats, la puissance fournie par le faisceau d'implantation, le contact thermique des substrats pendant l'implantation. De plus, l'implantation étant réalisée sous vide, il est très difficile de mesurer et de maintenir la température des substrats implantés tout au long de l'étape d'implantation qui peut durer plusieurs heures.

Or, les expériences du demandeur ont montré que la température d'implantation optimale d'hydrogène pour favoriser la fracture thermique dans l'InP est comprise entre 120 et 180°C. Toutefois, lorsque les substrats d'InP disponibles sont implantés avec un implanteur classique de microélectronique, la température d'implantation dépasse 200°C (205°C par exemple pour une implantation à 20keV et 100 microampères sur un substrat d'un diamètre de 50mm) et de ce fait la fracture par traitement thermique ultérieur n'est plus possible.

Un des buts de l'invention est de pallier un ou plusieurs de ces inconvénients. A cet effet l'invention a pour objet un procédé de transfert d'un film d'InP sur un substrat raidisseur, le procédé comprenant les étapes consistant à :

    a) Fournir une structure comprenant une couche superficielle d'InP et une couche mince d'InP dopée sous jacente, la couche mince dopée comprenant une concentration de dopants électriquement actifs comprise entre 10$^{17}$ à 10$^{20}$ at/cm$^3$ de sorte que la couche mince dopée présente une émissivité comprise entre 0.75 et 0.9,

    b) Implanter des ions hydrogène au travers de la couche superficielle de sorte à créer un plan fragilisé dans la couche mince dopée, délimitant un film comprenant la couche superficielle, l'étape b) comprenant une étape d'implantation d'ions hydrogène avec une énergie et une densité de courant, ladite énergie et ladite densité de courant et le dopage de la couche mince dopée au niveau du plan fragilisé étant tels que la température d'implantation dans la couche mince dopée est comprise entre 120 et 180°C,

    c) Mettre en contact intime la couche superficielle avec un substrat raidisseur, et

    d) Appliquer un traitement thermique de sorte à obtenir une fracture au niveau du plan fragilisé et un transfert du film sur le substrat raidisseur.

En effet, les substrats d'InP actuellement disponibles sont majoritairement fournis sous forme de substrats présentant une résistivité de l'ordre de 10$^7$ ohm.cm. Or cette résistivité implique une émissivité relativement faible, de l'ordre de 0.4 à 0.46. En appliquant la loi de Stephan Boltzman (dont l'équation est décrite ci-dessous), il découle que plus l'émissivité du matériau est importante plus la température atteinte dans le matériau lors de l'implantation est faible.

On rappelle que l'équation de Stephan Boltzman s'énonce de la manière suivante :

$$T = T_o \left( \frac{UI}{\varepsilon\sigma} \right)^{1/4}$$

$T_0$ représentant la température de la chambre d'implantation (température ambiante), T représentant la température d'implantation dans le matériau, U représentant l'énergie d'implantation (en V), I représentant la densité de courant (en A/m$^2$) et σ étant la constante de Stefan-Boltzmann de $5,67.10^{-12}$ $W.cm^2.K^{-4}$.

Or la résistivité du matériau a une incidence directe sur son emissivité. Le dopage du matériau par des éléments électriquement actifs de l'étape a) du procédé selon l'invention permet de diminuer la résistivité de la couche mince et par la même permet d'augmenter son emissivité, jusqu'à atteindre 0.75 - 0.9 pour l'InP. De ce fait, la température d'implantation dans la couche dopée de plus forte émissivité est diminuée par comparaison à un matériau non dopé de plus faible émissivité. Ainsi, le procédé de l'invention permet d'obtenir une fracture thermique selon la technologie Smart Cut™ parfaitement reproductible, même en utilisant un implanteur classique. Par le terme 'film', il est entendu dans le présent document une couche mince de matériau d'une épaisseur pouvant varier de quelques dizaines de nanomètres à quelques micromètres.

Selon une possibilité, l'étape c) de mise en contact intime comprend au préalable le dépôt d'une couche de SiO2 sur les surfaces mises en contact respectivement de la couche superficielle et du substrat raidisseur de sorte à renforcer le collage direct (encore appelé collage par adhésion moléculaire) et faciliter la fracture ultérieure.

Selon une disposition particulière, la couche superficielle est dopée avec le même dopant que la couche mince dopée, et de préférence avec la même concentration de dopants. De la sorte, la structure est simple à fabriquer. Selon l'invention, la couche mince dopée comprend une concentration de dopants électriquement actifs comprise entre $10^{17}$ à $10^{20}$ at/cm$^3$ de sorte que la couche mince d'InP dopée présente une émissivité comprise entre 0.75 et 0.9, de sorte à être adaptée au transfert par traitement thermique.

Grâce à ce procédé, il est ainsi possible de limiter la température d'implantation dans la couche d'InP dopée dans une fourchette optimale comprise entre 120 et 180°C pour ainsi par la suite obtenir une fracture thermique, tout en utilisant un implanteur classique de microélectronique. Par 'implanteur classique de microélectronique', on entend dans le présent document un implanteur dont les caractéristiques sont les suivantes :

- courant d'implantation entre quelques microampères et quelques milliampères,
- énergie d'implantation entre quelques KeV et quelques centaines de KeV,
- surface du faisceau entre quelques mm$^2$ et quelques cm$^2$,
- balayage mécanique ou électrostatique ou mixte.

Il est entendu que l'émissivité comprise entre 0.75 et 0.9 de l'InP dopé est obtenue entre autre au niveau de la profondeur d'implantation des ions hydrogène, c'est-à-dire au niveau du plan fragilisé.

Le procédé selon l'invention propose ainsi une solution simple et facile à mettre en oeuvre pour obtenir le transfert reproductible d'un film d'InP et notamment d'InP résistif.

Selon un mode de réalisation possible, l'étape a) comporte les étapes consistant à

i) fournir un substrat d'InP résistif,
ii) implanter des espèces ioniques dopantes, telles que le S, Sn, Zn, Si, Te, Ge ou le Se, dans le substrat de sorte à former une couche enterrée implantée délimitant une couche superficielle entre la surface implantée et la couche enterrée,
iii) appliquer un traitement thermique à la couche enterrée de sorte à électriquement activer les espèces ioniques dopantes et former une couche mince dopée dans un matériau en InP présentant une émissivité comprise entre 0.75 et 0.9, de sorte à obtenir la structure.

Ainsi, la préparation de la structure permettant d'atteindre une émissivité élevée du matériau InP est simple à mettre en place, reproductible et peu coûteuse. Le traitement thermique d'activation des dopants peut être réalisé dans un four RTA (RTA pour Rapid Thermal Annealing) présentant une rampe de montée en température rapide (typiquement 1000°C en quelques secondes) ou un four conventionnel. Par l'expression 'InP résistif' on entend dans le présent document un matériau d'InP dont la résistivité est supérieure à $10^7$ ohm.cm, à $10^8$ ohm.cm, voire plus.

Avantageusement, la structure est entièrement formée en InP de sorte que les coefficients de dilatation thermique sont identiques pour toutes les couches de la structure. Ceci induit une dilatation identique des différentes couches lors des différents traitements thermiques appliqués. De la sorte, la génération de défauts cristallins dans la couche superficielle, et donc dans le film à transférer, susceptible d'avoir lieu par différence de dilation est évitée. Par ailleurs, il est possible de réutiliser le substrat après le transfert du film pour une nouvelle étape d'implantation. Le substrat peut ainsi être recyclé plusieurs fois.

Selon un mode de réalisation alternatif, l'étape a) comprend les étapes consistant à

j) - fournir un substrat comprenant en surface une couche germe,
k) - épitaxier une couche mince dopée d'InP sur la couche germe et,
l) - épitaxier une couche superficielle d'InP sur la couche mince dopée, la couche mince dopée présentant une émissivité comprise entre 0.75 et 0.9, de sorte à obtenir la structure.

De préférence, la couche germe présente un paramètre de maille adapté à l'épitaxie d'InP.

Avantageusement, la couche germe comprend de l'InP résistif.

Dans cette variante, il est possible de réaliser la totalité de la structure dans le même bâti d'épitaxie ce qui évite la manipulation de la structure aux différents stades de sa fabrication, diminue le risque d'endommagement et permet une grande rapidité d'execution.

Selon une possibilité, le substrat est formé de la couche germe. Ainsi, les coefficients de dilatation thermique sont identiques pour toutes les couches de la structure de sorte que leur dilatation est similaire lors des différents traitements thermiques appliqués, ce qui évite génération de défauts dans le matériau.

Selon une autre possibilité, le substrat comprend la couche germe collée sur un substrat support. Le choix de la nature du substrat support est alors affranchi de son paramètre de maille, il peut ainsi être choisi de sorte à être peu coûteux et de préférence présentant un coefficient de dilatation thermique CTE similaire à celui de la couche germe.

De préférence, la couche superficielle d'InP est formée en InP résistif choisi parmi de l'InP intrinsèque ou de l'InP dont le dopage est compensé par une concentration de dopants électriquement activés en Fe de l'ordre de $10^{15}$ à $10^{16}$ Fe/cm$^3$. Typiquement, la résistivité d'un tel matériau est de l'ordre de quelques $10^7$ ohm.cm, par exemple entre $2.10^7$ et $10^8$ ohm.cm, voire supérieure.

Il est ainsi possible d'utiliser les substrats résistifs d'InP les plus couramment disponibles et les moins onéreux et notamment en grande dimension (avec un diamètre typiquement supérieur à 50mm) tout en optimisant la qualité du film d'InP transféré. La structure obtenue par le procédé de l'invention est avantageusement utilisée dans des applications telles que la fabrication par épitaxie de cellules photovoltaïques de matériaux III-V à multi-jonctions.

De préférence, l'étape b) comprend une étape d'implantation d'ions hydrogène avec une énergie et une densité de courant tels que la température d'implantation dans la couche mince dopée est comprise entre 120 et 180°C. De la sorte, il est possible d'obtenir avec un implanteur classique facilement disponible et d'utilisation peu coûteuse, une fracture thermique reproductible dans l'InP.

D'autres aspects, buts et avantages de la présente invention apparaîtront mieux à la lecture de la description suivante de deux modes de réalisation de celle-ci, donnés à titre d'exemples non limitatifs et faits en référence aux dessins annexés. Les figures ne respectent pas nécessairement l'échelle de tous les éléments représentés de sorte à améliorer leur lisibilité. Des traits pointillés symbolisent un plan de fragilisation. Dans la suite de la description, par souci de simplification, des éléments identiques, similaires ou équivalents des différentes formes de réalisation portent les mêmes références numériques.

Les figures 1 à 7 représentent un mode de réalisation du procédé selon l'invention.

Les figures 8 à 13 représentent un deuxième mode de réalisation du procédé selon l'invention.

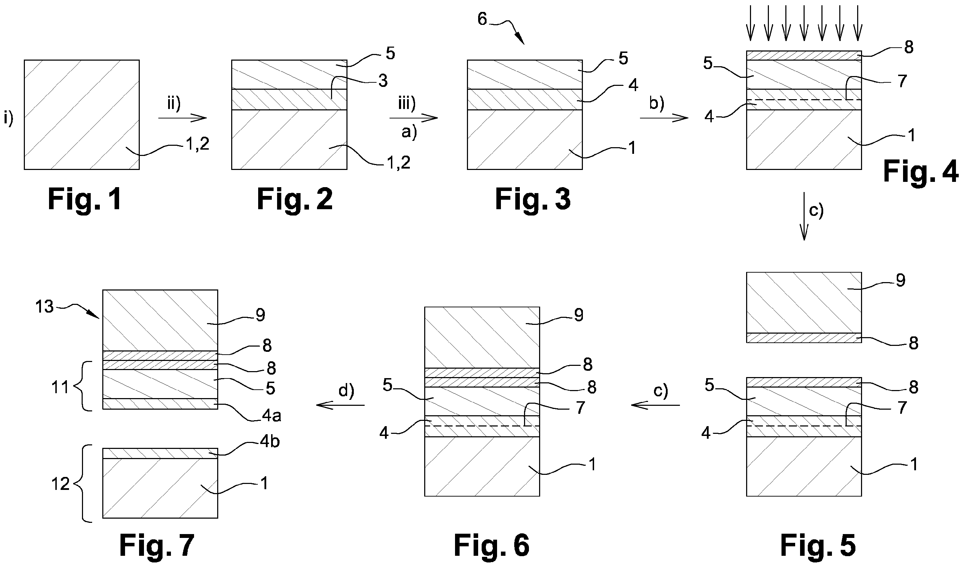

La figure 1 illustre un substrat 1 formé d'une couche initiale 2, par exemple en InP résistif dont le diamètre est de 50 mm (étape i). La figure 2 illustre une implantation d'espèces ioniques dopantes par exemple des ions Si$^+$ avec une énergie d'environ 150 KeV et une dose d'environ $5.10^{14}$ Si/cm$^2$ de sorte à former une couche enterrée 3 implantée dans la couche initiale 2 (étape ii). La figure 3 illustre l'application d'un traitement thermique dans un four rapide (RTA), dans le cas présent à une température d'environ 850°C pendant 5 secondes, de sorte à activer électriquement les espèces dopantes implantées et à ce que la couche enterrée 3 devienne une couche mince 4 dopée avec une concentration de dopants activés allant de $2.10^{18}$ à $3.10^{19}$ Si/cm$^2$ selon le profil d'implantation. Dans le cas présent, cette couche mince 4 dopée se trouve à une profondeur comprise entre 0 et 300 nm sous la surface implantée du substrat 1 (étape iii), la couche superficielle 5 constitue alors la partie superficielle de la couche mince 4 dopée et est donc également dopée. Il serait possible en variante d'implanter plus profondément pour obtenir en surface une couche superficielle 5 plus résistive ou encore de réépitaxier une couche superficielle d'InP (et notamment d'InP résistif) à la surface. Les deux couches mince 4 et superficielle 5 forme la structure 6. Du fait du dopage, la couche mince 4 présente une émissivité supérieure à celle du substrat, et dans le cas présent une émissivité de l'ordre de 0.75-0.9 au lieu de 0.4-0.46 pour un matériau d'InP résistif.

La figure 4 illustre une étape du procédé (étape b) consistant à implanter des espèces ioniques dans la structure 6, au travers la couche superficielle 5 et de sorte à former un plan fragilisé 7 dans la couche mince 4 dopée. Dans le mode de réalisation illustré, la structure 6 est recouverte au préalable d'une couche d'oxyde de silicium 8 SiO$_2$ déposée par PECVD (acronyme anglais de Plasma Enhanced Chemical Vapor Deposition) sur une épaisseur d'environ 10 nm de sorte à éviter d'endommager la surface d'InP lors de l'implantation. Cette couche d'oxyde 8 peut ensuite servir pour le collage par adhésion moléculaire dans une étape ultérieure. Puis, l'implantation est réalisée avec un implanteur classique, un implanteur Varian E200-1000 dans le cas illustré, fonctionnant à moyen courant avec un balayage électrostatique. La surface totale balayée par le faisceau d'espèces ioniques est de 9cm$^2$ (3cmx3cm). De manière générale, les paramètres d'implantation sont déterminés de sorte que le plan fragilisé 7 soit formé au sein de la couche mince 4 dopée, le dopage de cette couche mince au niveau du plan fragilisé permettant de limiter la température d'implantation dans une plage de 120-180°C. Dans le cas présent, les espèces ioniques implantées sont formées à partir d'hydrogène et l'implantation est effectuée avec une énergie d'environ 20keV, une dose d'environ $7^E16$ H/cm$^2$ et un courant de 50$\mu$A. Dans ces conditions, la profondeur d'implantation des ions H$^+$ est d'environ 200nm, de sorte que le plan fragilisé 7 se situe au niveau de la localisation de la couche mince 4 d'InP dopée n$^+$.

La température d'implantation atteinte dans la couche mince 4 dopée est de l'ordre de 140°C, elle se situe dans la plage de températures d'implantation optimales de l'InP pour obtenir la fracture (entre 120-180°C).

Les figures 5 et 6 illustrent une étape de mise en contact intime de la surface de la couche superficielle 5, recouverte dans le cas présent de la couche 8 de SiO2, avec un substrat raidisseur 9, ici en saphir (étape c). La figure 5 illustre plus précisément la préparation du substrat raidisseur 9 de saphir sur lequel une couche d'oxyde de silicium 8 SiO$_2$ est déposée par PECVD sur une épaisseur d'environ 10 nm puis densifiée par un recuit thermique, nettoyée et polie mécano-chimiquement par CMP (acronyme anglais de Chemical Mechanical Polishing). La figure 6 illustre la mise en contact intime des surfaces des deux couches 8 de SiO2 présentes respectivement sur la couche superficielle 5 et le substrat raidisseur 9.

La figure 7 illustre une étape du procédé consistant à appliquer un traitement thermique pour provoquer la fracture au niveau du plan fragilisé 7 localisé dans la couche mince 4 dopée (étape d). En l'occurrence dans l'exemple décrit le traitement thermique est appliqué avec une température comprise entre 200 à 300°C. Un film 11 délimité entre la surface de la structure 6 et le plan fragilisé 7 comprenant la couche superficielle 5 et une portion résiduelle 4a de la couche mince dopée 4 est ainsi transféré sur le substrat raidisseur 9 tandis que le négatif 12 de la structure 6 implantée, comprenant le substrat 1 et une portion résiduelle 4b opposée à la portion résiduelle 4a selon le plan fragilisé 7, peut être récupéré. En effet, selon une possibilité non illustrée, le négatif 12 peut être recyclé pour une réutilisation dans la préparation d'une nouvelle structure 6 et le transfert d'un nouveau film 11. Dans le cas représenté à la figure 7, un film 11 d'InP d'un épaisseur d'environ 200 nm est transféré sur un substrat raidisseur 9 de saphir. La structure finale 13 obtenue peut avantageusement être utilisée pour servir de germe à l'épitaxie de couches de matériaux III-V formant des cellules photovoltaïques III-V à multi-jonctions (non illustré).

Selon une variante non illustrée, le substrat 1 peut être formé à partir d'une couche initiale 2 en surface, collée au préalable ou formée par épitaxie sur un support.

Egalement, les espèces ioniques dopantes peuvent être choisies parmi le S, Sn, Zn, Si, Te, Ge et le Se.

Selon une possibilité non représentée, le substrat raidisseur 9 peut être constitué de tout matériau permettant un bon collage par adhésion moléculaire avec le film 11, permettant de procurer un bon effet raidisseur pour la fracture et également en fonction des applications ultérieures envisagées.

Par ailleurs, la surface du film 11 transféré peut être préparée en vue d'étapes ultérieures.

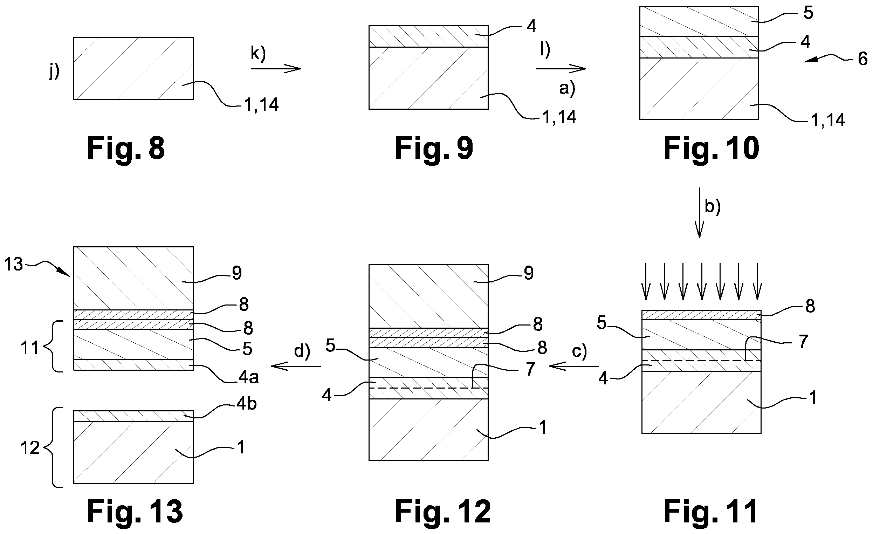

La figure 8 illustre un substrat 1 formé d'une couche germe 14, présentant un paramètre de maille adapté pour la croissance épitaxiale de l'InP. Il peut s'agir avantageusement d'InP résistif. La figure 9 illustre une première épitaxie d'une couche mince 4 d'un matériau dopé, tel que de l'InP dopé avec une concentration de dopants électriquement actifs comprise entre 1.10$^{17}$ à 1.10$^{20}$ at/cm$^3$ permettant d'atteindre une émissivité locale d'environ 0.75. La figure 10 illustre une deuxième épitaxie servant à former une couche superficielle 5, en InP résistif dans le cas présent, sur la couche mince 4 dopée. Puis, selon le mode de réalisation précédemment illustré aux figures 4 à 7, la figure 11 illustre une implantation d'espèces ioniques avec un implanteur classique (20keV- 100 microampères) permettant d'atteindre une température d'implantation de l'ordre de 175°C et de former un plan fragilisé 7 dans la couche mince 4 dopée. Dans un matériau d'InP non dopé présentant une résistivité de l'ordre de quelques 10$^7$ ohm.cm et une émissivité de l'ordre de 0.4, la température d'implantation aurait atteint environ 205°C. La figure 12 illustre la mise en contact intime des surfaces de deux couches 8 de SiO2 recouvrant respectivement la structure 6 implantée et un substrat raidisseur 9. La figure 13 illustre l'application d'un traitement thermique de fracture de l'InP au niveau du plan fragilisé 7 permettant le transfert d'un film 11 d'InP sur le substrat raidisseur 9.

Ainsi, la présente invention propose un procédé de transfert de film 11 d'InP selon une température d'implantation optimale grâce au dopage local à la profondeur du plan fragilisé 7 de sorte à localement élever l'émissivité du matériau, qui est simple à mettre en oeuvre.

**Revendications**

1. Procédé de transfert d'un film d'InP (11) sur un substrat raidisseur (9), le procédé comprenant les étapes consistant à :

   a) Fournir une structure (6) comprenant une couche superficielle (5) d'InP et une couche mince (4) d'InP dopée sous jacente, la couche mince (4) dopée comprenant une concentration de dopants électriquement actifs comprise entre 10$^{17}$ à 10$^{20}$ at/cm$^3$ de sorte que la couche mince (4) dopée présente une émissivité comprise entre 0.75 et 0.9,

   b) Implanter des ions hydrogène au travers de la couche superficielle (5) de sorte à créer un plan fragilisé (7) dans la couche mince (4) dopée, délimitant un film (11) comprenant la couche superficielle (5), l'étape b) comprenant une étape d'implantation d'ions hydrogène avec une énergie et une densité de courant, ladite énergie et ladite densité de courant et le dopage de la couche mince (4) dopée au niveau du plan fragilisé (7) étant tels que la température d'implantation dans la couche mince (4) dopée est comprise entre 120 et 180°C,

   c) Mettre en contact intime la couche superficielle (5) avec un substrat raidisseur (9), et

d) Appliquer un traitement thermique de sorte à obtenir une fracture au niveau du plan fragilisé (7) et un transfert du film (11) sur le substrat raidisseur (9).

2. Procédé selon la revendication 1, **caractérisé en ce que** la couche superficielle (5) est dopée avec le même dopant que le dopant de la couche mince (4) dopée.

3. Procédé selon l'une des revendications 1 à 2, **caractérisé en ce que** l'étape a) comporte les étapes consistant à

> i) fournir un substrat d'InP résistif (1),
> ii) implanter des espèces ioniques dopantes, telles que le S, Sn, Zn, Si, Te, Ge ou le Se, dans le substrat (1) de sorte à former une couche enterrée (3) dopée délimitant une couche superficielle (5) entre la surface implantée et la couche enterrée (3),
> iii) appliquer un traitement thermique à la couche enterrée (3) de sorte à électriquement activer les espèces ioniques dopantes et former une couche mince (4) dopée dans un matériau en InP présentant une émissivité comprise entre 0.75 et 0.9, de sorte à obtenir la structure (6).

4. Procédé selon l'une des revendications 1 à 2, **caractérisé en ce que** l'étape a) comprend les étapes consistant à

> j) - fournir un substrat (1) comprenant en surface une couche germe (14),
> k) - épitaxier une couche mince (4) dopée d'InP sur la couche germe (14) et,
> l) - épitaxier une couche superficielle (5) d'InP sur la couche mince (4) dopée, la couche mince (4) dopée présentant une émissivité comprise entre 0.75 et 0.9, de sorte à obtenir la structure (6).

5. Procédé selon la revendication 4, **caractérisé en ce que** la couche germe (14) comprend de l'InP résistif.

6. Procédé selon l'une des revendications 1 ou 3 à 5, **caractérisé en ce que** la couche superficielle (5) d'InP est formée en InP résistif choisi parmi de l'InP intrinsèque ou de l'InP dont le dopage est compensé par une concentration de dopants électriquement activés en Fe de l'ordre de $10^{15}$ à $10^{16}$ Fe/cm$^3$.

**Patentansprüche**

1. Verfahren zur Übertragung eines InP-Films (11) auf ein Versteifungssubstrat (9), wobei das Verfahren die Schritte umfasst, die aus Folgendem bestehen:

a) Bereitstellen einer Struktur (6), umfassend eine InP-Oberflächenschicht (5) und eine dotierte darunter liegende dünne InP-Schicht (4), wobei die dotierte dünne Schicht (4) eine Konzentration von elektrisch aktiven Zusatzstoffen im Bereich zwischen $10^{17}$ bis $10^{20}$ at/cm$^3$ umfasst, so dass die dotierte dünne Schicht (4) eine Emissionsfähigkeit im Bereich zwischen 0,75 und 0,9 aufweist,

b) Implantieren von Wasserstoffionen durch die Oberflächenschicht (5), um eine geschwächte Ebene (7) in der dotierten dünnen Schicht (4) zu erzeugen, die einen Film (11) begrenzt, der die Oberflächenschicht (5) umfasst, wobei der Schritt b) einen Schritt zur Implantierung von Wasserstoffionen mit einer Energie und einer Stromdichte umfasst, wobei die Energie und die Stromdichte und die Dotierung der dünnen Schicht (4), dotiert auf dem Niveau der geschwächten Ebene (7), derart sind, dass die Temperatur der Implantierung in der dotierten dünnen Schicht (4) im Bereich zwischen 120 und 180 °C liegt,

c) In-engen-Kontakt-Bringen der Oberflächenschicht (5) mit einem Versteifungssubstrat (9), und

d) Anwenden einer thermischen Behandlung, um einen Bruch auf dem Niveau der geschwächten Ebene (7) und eine Übertragung des Films (11) auf das Versteifungssubstrat (9) zu erhalten.

2. Verfahren nach Anspruch 1, **dadurch gekennzeichnet, dass** die Oberflächenschicht (5) mit dem gleichen Zusatzstoff als dem Zusatzstoff der dünnen Schicht (4) dotiert ist.

3. Verfahren nach einem der Ansprüche 1 bis 2, **dadurch gekennzeichnet, dass** der Schritt a) die Schritte enthält, die aus Folgendem bestehen

> i) Bereitstellen eines resistiven InP-Substrats (1),
> ii) Implantieren der dotierenden ionischen Spezies, wie z. B. S, Sn, Zn, Si, Te, Ge oder Se, in das Substrat (1), um eine dotierte versenkte Schicht (3) zu bilden, die eine Oberflächenschicht (5) zwischen der implantierten Fläche und der versenkten Schicht (3) begrenzt,
> iii) Anwenden einer thermischen Behandlung auf die versenkte Schicht (3), um die dotierenden ionischen Spezies elektrisch zu aktivieren und um eine dünne Schicht (4), dotiert in einem Material aus InP, zu bilden, die eine Emissionsfähigkeit im Bereich zwischen 0,75 und 0,9 aufweist, um die Struktur (6) zu erhalten.

4. Verfahren nach einem der Ansprüche 1 bis 2, **da-**

**durch gekennzeichnet, dass** der Schritt a) die Schritte umfasst, die aus Folgendem bestehen

> j) - Bereitstellen eines Substrats (1), umfassend auf der Oberfläche eine Keimschicht (14),
> k) - Epitaxieren einer dotierten dünnen InP-Schicht (4) auf der Keimschicht (14), und
> l) - Epitaxieren einer InP-Oberflächenschicht (5) auf der dotierten dünnen Schicht (4), wobei die dotierte dünne Schicht (4) eine Emissionsfähigkeit aufweist, die im Bereich zwischen 0,75 und 0,9 liegt, um die Struktur (6) zu erhalten.

5. Verfahren nach Anspruch 4, **dadurch gekennzeichnet, dass** die Keimschicht (14) resistives InP umfasst.

6. Verfahren nach einem der Ansprüche 1 oder 3 bis 5, **dadurch gekennzeichnet, dass** die InP-Oberflächenschicht (5) aus resistivem InP gebildet ist, ausgewählt aus intrinsischem InP oder InP, dessen Dotierung durch eine Konzentration von elektrisch mit Fe im Bereich von $10^{15}$ bis $10^{16}$ Fe/cm$^3$ aktivierten Zusatzstoffen kompensiert ist.

**Claims**

1. A method for transferring an InP film (11) onto a stiffener substrate (9), the method comprising the steps consisting of:

> a) Providing a structure (6) comprising a surface layer (5) of InP and an underlying doped thin InP layer (4), the doped thin layer (4) comprising a concentration of electrically active dopants of between $10^{17}$ and $10^{20}$ at/cm$^3$ so that the doped thin layer (4) has an emissivity of between 0.75 and 0.9,
> b) Implanting hydrogen ions through the surface layer (5) so as to create a weakened plane (7) in the doped thin layer (4), delimiting a film (11) comprising the surface layer (5), the step b) comprising a step to implant hydrogen ions at an energy and current density, said energy and said current density and the doping of the thin layer (4) being such that the implantation temperature in the doped thin layer (4) is between 120 and 180°C,
> c) Placing the surface layer (5) in close contact with a stiffener substrate (9), and
> d) Applying heat treatment to obtain splitting at the weakened plane (7) and transfer of the film (11) onto the stiffener substrate (9).

2. The method according to claim 1, **characterized in that** the surface layer (5) is doped with the same dopant as the dopant of the doped thin layer (4).

3. The method according to one of claims 1 to 2, **characterized in that** step a) comprises the steps consisting of:

> i) providing a substrate of resistive InP (1);
> ii) implanting dopant ion species such as S, Sn, Zn, Si, Te, Ge or Se in the substrate (1) so as to form a doped buried layer (3) delimiting a surface layer (5) between the implanted surface and the buried layer (3);
> iii) applying heat treatment to the buried layer (3) so as electrically to activate the dopant ion species and to form a doped thin layer (4) in InP material having an emissivity of between 0.75 and 0.9, in order to obtain the structure (6).

4. The method according to one of claims 1 to 2, **characterized in that** step a) comprises the steps consisting of:

> j) - providing a substrate (1) comprising a seed layer (14) on its surface;
> k) - epitaxying a doped thin InP layer (4) on the seed layer (14); and
> l) - epitaxying an InP surface layer (5) on the doped thin layer (4), the doped thin layer (4) having an emissivity of between 0.75 and 0.9, so as to obtain the structure (6).

5. The method according to claim, 5 **characterized in that** the seed layer (14) comprises resistive InP.

6. The method according to one of claims 1 or 3 to 5, **characterized in that** the InP surface layer (5) is formed of resistive InP chosen from among intrinsic InP or InP whose doping is compensated by a concentration of electrically activated Fe dopants in the order of $10^{15}$ to $10^{16}$ Fe/cm$^3$.

i) → ii) → Fig. 2 → iii) a) → Fig. 3 → b) → Fig. 4

Fig. 1

Fig. 2 — 5, 3, 1,2

Fig. 3 — 6, 5, 4, 1

Fig. 4 — 8, 5, 7, 4, 1

c)

Fig. 5 — 9, 8, 5, 8, 7, 4, 1

c) → Fig. 6

Fig. 6 — 9, 8, 5, 8, 7, 4, 1

d) → Fig. 7

Fig. 7 — 13, 9, 8, 8, 5, 4a, 11, 4b, 1, 12

EP 2 701 185 B1

Fig. 8

Fig. 9

Fig. 10

Fig. 11

Fig. 12

Fig. 13

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 2008311686 A

**Littérature non-brevet citée dans la description**

• DE Q.-Y. TONG ; Y.-L. CHAO ; L.-J. HAUNG ; U. GÖSELE. Low temperature InP layer transfer. *Electron.Lett.,* 1999, vol. 35, 341

• DE S. HAYASHI ; D. BRUNO ; M.S.GOORSKY. Temperature dependence of hydrogen-induced exfoliation of InP. *Appl. Phys. Lett.,* 12 Juillet 2004, vol. 85, 236-238